# EUROPEAN PATENT APPLICATION

(11) **EP 2 881 256 A1**
(43) Date of publication of application: **10.06.2015**
(21) Application number: 13195478.6
(22) Date of filing: 03.12.2013
(51) Int. Cl.: B41F 15/08, B41F 15/42, B41F 15/44, B41F 15/46, H01L 31/18, H05K 3/12

(54) **Apparatus and method for screen printing on a substrate**

(71) Applicant: APPLIED MATERIALS ITALIA S.R.L., 31048 San Biagio di Callalta (TV) (IT)
(72) Inventor: Vercesi, Tommaso, 31057 Silea (IT); Sonego, Mauro, 31046 Rustignè di Oderzo (TV) (IT)
(74) Representative: Zimmermann & Partner Patentanwälte mbB

(57) **Abstract**

An apparatus (100, 200) and a corresponding method for screen printing on a substrate (200) is disclosed. The apparatus (100, 200) for screen printing on a substrate (120) includes a substrate support (110) configured to support the substrate (120), a squeegee (142), a screen device (130) provided between the substrate support (110) and the squeegee (142), wherein the squeegee (142) is moveable in at least one direction along the screen device (130) for printing, and a control device configured to control, during printing, one or more print parameters of the squeegee (142) according to a predetermined pattern.

## Description

### TECHNICAL FIELD OF THE INVENTION

Embodiments of the present disclosure relate to an apparatus for screen printing on a substrate; in particular in the solar cell production, a solar cell production apparatus, and a method for screen printing on a substrate. Embodiments of the present disclosure particularly relate to an apparatus for screen printing, a solar cell production apparatus and a method for screen printing on a substrate used to form photovoltaic (PV) cells.

### BACKGROUND OF THE DISCLOSURE

Solar cells are PV devices that convert sunlight directly into electrical power. Within this field, it is known to produce solar cells on a crystalline silicon base by means of screen printing techniques, achieving on the front surface of the solar cells a structure of selective emitters. Some disadvantages in the field of production of photovoltaic cells are connected to a non-uniform geometry of the printed structures caused by shortcomings of conventional screen printing apparatuses. Such a non-uniform geometry of the printed structures affects the electric properties of said printed structures. Since the electric properties are crucial for a performance and reliability of the solar cells, there is a need to provide a screen printing apparatus that allows printing uniform structures.

In view of the above, it is an object of the present invention to provide an apparatus for screen printing on a substrate, particularly an apparatus for screen printing on a substrate used to form photovoltaic (PV) cells, that overcomes at least some of the problems in the art.

### SUMMARY OF THE DISCLOSURE

In light of the above, an apparatus for screen printing on a substrate, a solar cell production apparatus, and a method for screen printing on a substrate are provided. Further aspects, advantages, and features of the present invention are apparent from the dependent claims, the description, and the accompanying drawings.

According to one embodiment, an apparatus for screen printing on a substrate includes a substrate support configured to support the substrate, a squeegee, a screen device provided between the substrate support and the squeegee, wherein the squeegee is moveable in at least one direction along the screen device for printing, and a control device configured to control, during printing, one or more print parameters of the squeegee, wherein at least one of the one or more print parameters is amended during printing according to a predetermined pattern.

According to another embodiment, an apparatus for screen printing on a substrate includes a substrate support configured to support the substrate, a recovery device moveable in at least one direction along the substrate for recovery of excess print material, and a control device configured to control, during operation, particularly a recovery operation or printing, one or more recovery parameters of the recovery device, wherein at least one of the one or more recovery parameters is amended during operation according to a predetermined pattern.

According to one embodiment, an apparatus for screen printing on a substrate includes a substrate support configured to support the substrate, a squeegee, a screen device provided between the substrate support and the squeegee, wherein the squeegee is moveable in at least one direction along the screen device for printing, and a control device configured to adjust an angle of the squeegee with respect to the screen device during printing according to a predetermined pattern.

According to one embodiment, a solar cell production apparatus is provided, including one or more printing stations, at least one of them having the above apparatus for screen printing.

According to one embodiment, a method for screen printing on a substrate is provided. The method includes contacting a screen by the squeegee, moving the squeegee with respect to the screen for printing, and controlling, during printing, one or more print parameters of the squeegee, wherein at least one of the one or more print parameters is amended according to a predetermined pattern.

The term "predetermined pattern" may particularly refer to a control pattern which is defined before the printing process. In particular, the printing process may not have an influence on the predetermined pattern.

According to one embodiment, a method for screen printing on a substrate is provided. The method includes contacting a screen by the squeegee, moving the squeegee with respect to the screen for printing, and adjusting, during printing, an angle of the squeegee with respect to the screen device.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the invention and are described in the following:
- FIG. 1: illustrates an apparatus for screen printing on a substrate according to embodiments disclosed herein;
- FIG. 2: illustrates the apparatus for screen printing with the squeegee contacting the screen at an initial position;
- FIG. 3: illustrates the apparatus for screen printing with the squeegee contacting the screen during printing;
- FIG. 4: illustrates the apparatus for screen printing with the squeegee contacting the screen at a final position after completion of the printing process;
- FIG. 5: illustrates another apparatus for screen printing on a substrate according to embodiments disclosed herein;
- FIG. 6: illustrates a predetermined pattern for controlling a print parameter of the squeegee during printing according to embodiments disclosed herein; and
- FIG. 7: shows a flowchart of a method for screen printing on a substrate according to embodiments described herein.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

Although the following description mainly refers to screen printing on a substrate used to form photovoltaic (PV) cells, the disclosure is not limited to manufacturing of solar cells. Particularly, the present embodiments could be used for any screen printing techniques.

According to some embodiments, which could be combined with other embodiments described herein, the apparatus 100 for screen printing on a substrate 120 includes a substrate support 110 configured to support the substrate 120, a squeegee 142, a screen device 130 provided between the substrate support 110 and the squeegee 142, wherein the squeegee 142 is moveable in at least one direction along the screen device 130 for printing, and a control device (not shown) configured to control, during printing, one or more print parameters of the squeegee 142 according to a predetermined pattern.

Quality issues may particularly arise at the beginning and at the end of the printing step, where the printing quality could be affected by a finger/busbar enlargement. Further, it might be required to consider different printing conditions, e.g., pressure, as a function of the screen region. Quality issues might also arise in regard to a shape of the fingers/busbars. According to the embodiments described herein, to address at least some a said quality issues and for an improvement of printing, dynamic variations (i.e., real-time variations during printing) of at least one of the print parameters is performed in order to obtain an improved printing, e.g., on solar cells. Thereby, an improved quality in terms of printing homogeneity, correct dimensions (e.g., height and/or width) of the printed structures (e.g., fingers and/or busbars) can be achieved.

According to some embodiments, which could be combined with other embodiments described herein, the one or more print parameters include at least one of an angle 147, 148 of the squeegee 142 with respect to the screen device 130, a moving speed of the squeegee 142 with respect to the screen device 130, and a pressure or force of the squeegee 142 acting on the screen device 130, the substrate 120 and/or the substrate support 110. By controlling or adjusting at least one of said parameters during printing, different printing conditions for instance in different screen regions can be considered/accounted for, and thus, a homogeneity of the printed structures can be improved.

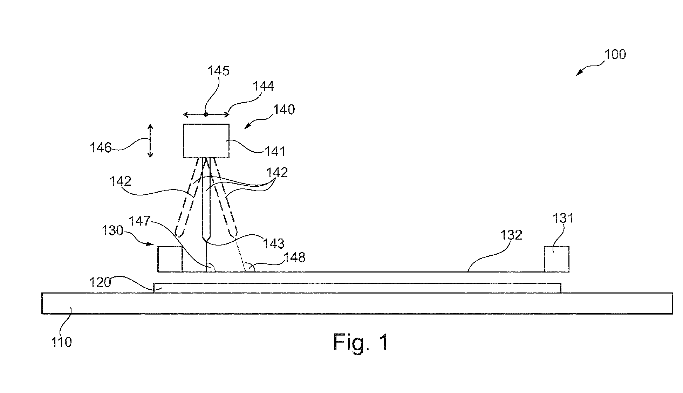

According to some embodiments, which could be combined with other embodiments described herein, the angle 147, 148 of the squeegee 142 with respect to the screen device 130 is defined as an angle between a surface of the screen device 130 or screen 132, and a longitudinal extension of the squeegee 142. In the embodiment shown in FIG. 1, when the squeegee 142 is oriented perpendicular to the screen device 130, the angle 147 is approximately 90°. In typical embodiments, the angle is adjustable by an amount Delta from its perpendicular orientation, where Delta may be approximately plus minus 45° (i.e., 45° to 135°), plus minus 35° (55° to 125°), plus minus 25° (65° to 115°), plus minus 15° (75° to 105°), or plus minus 5° (85° to 95°), or less.

According to some embodiments, which could be combined with other embodiments described herein, the moving speed of the squeegee 142 with respect to the screen device 130 is adjusted during printing according to the predetermined pattern. In typical embodiments, the screen 132 defines a pattern or features corresponding to a structure to be printed on the substrate 120, wherein the pattern or features may include at least one of holes, slots, incisions or other apertures. In typical embodiments, a tip 143 of the squeegee 142 contacts the screen 132, wherein the squeegee 142 urges material to be printed onto the substrate 120 through the screen 132.

According to some embodiments, the moving speed may be controlled based on a presence or density of the pattern or features of the screen 132. As an example, the moving speed may be controlled to be higher in screen regions where the pattern or features are present or a density thereof is high(er), and may be lower or reduced in other regions, e.g., regions having no pattern or features or having less density. According to some embodiments, the moving speed is higher at the beginning and the end of the printing process, and is reduced in between.

According to some embodiments, which could be combined with other embodiments described herein, during printing, the moving speed of the squeegee 142 with respect to the screen device 130 is in the range of 20 to 700 mm/s, and particularly 50 to 500 mm/s. According to some embodiments, which could be combined with other embodiments described herein, during flooding, the moving speed of the squeegee 142 with respect to the screen device 130 is in the range of 20 to 1200 mm/s, and particularly 50 to 1000 mm/s.

According to some embodiments, which could be combined with other embodiments described herein, the control device is configured to adjust the pressure of the squeegee 142 acting on the screen device 130 by controlling a distance (snap off) of the squeegee 142 with respect to the screen device 130. As an example, the squeegee 142 may be moveable in a direction perpendicular to the screen device 130, i.e., in z (146)-direction shown in FIG. 1. According to some embodiments, which could be combined with other embodiments described herein, the distance of the squeegee 142 with respect to the screen device 130 can be changed from about +20 mm to about -50 mm, and particularly from about +5 mm to about -35 mm, wherein the surface of the screen device 130 is positioned at 0 mm when it is not deformed, e.g., due to a contact of the squeegee 142 with said screen device 120. As an example, when the squeegee 142 is positioned at +5 mm, the screen is pushed down towards the substrate (or deformed) 5 mm, wherein, when the squeegee 142 is positioned at - 35 mm, it is positioned at a distance of 35 mm from the screen device 132.

According to some embodiments, which could be combined with other embodiments described herein, the predetermined pattern includes at least one of a sequence of print parameters based on printing time, and a sequence of print parameters based on a position of the squeegee 142 with respect to the screen device 130. Thus, the print parameters may be controlled or adjusted based on the predetermined pattern, which may for instance be stored in a memory of the apparatus. In typical embodiments, it is not required to provide any sensors, such a pressure sensors, for controlling the at least one print parameter, since the controlling may be performed based on the predetermined pattern, e.g., stored in advance. Thus, a complexity and manufacturing costs of the apparatus for screen printing can be reduced.

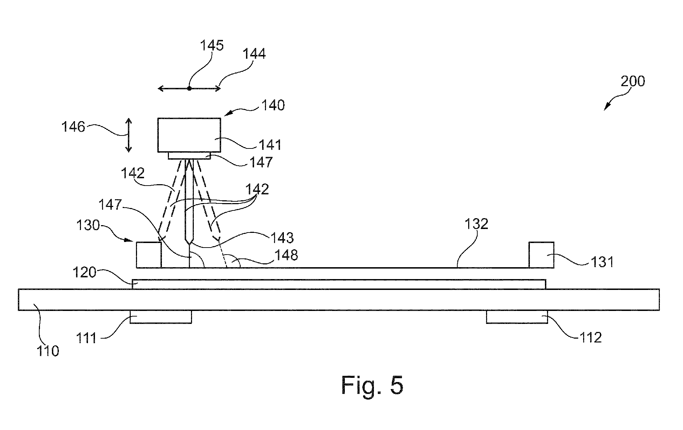

According to some embodiments, which could be combined with other embodiments described herein, the predetermined pattern may include two or more values for at least one print parameter. As an example, the predetermined pattern may include a first moving speed value and a second moving speed value, which values may be applied to the printing process in dependence on printing time or a position of the squeegee 142 with respect to the screen device 130. The latter may be (theoretically) determined from the moving speed and an elapsed printing time, without any sensors. In typical embodiments, sensors could be provided to determine the position of the squeegee 142 with respect to the screen device 130. As an example, the at least some of the pressure sensors described later with reference to FIG. 5 could be used to determine the position and/or the moving speed of the squeegee 142 with respect to the screen device 130.

According to some embodiments, which could be combined with other embodiments described herein, the apparatus 100 for screen printing may further include a processing device 140 having a translation device 141, which is configured for moving the squeegee 142 in the at least one direction with respect to the screen device 130. The squeegee 142 may be held by the processing device 140, which is moveable in at least one of x (144)-, y (145)-, and z (146)-direction with respect to the screen device 130.

According to some embodiments, which could be combined with other embodiments described herein, the squeegee 142 is attached or fixed to the translation device 141. In typical embodiments, the squeegee 142 is provided detachably. This allows a replacement of the squeegee 142 e.g. based on process requirements or when the squeegee 142 is damaged or worn.

According to some embodiments, which could be combined with other embodiments described herein, the translation device 141 is configured to adjust the one or more print parameters based on a control of the control device. In typical embodiments, the translation device 141 is configured to adjust an angle of the squeegee 142 with respect to the screen device 132, and/or to adjust a distance (snap off) of the squeegee 132 with respect to the screen device 132.

According to some embodiments, which could be combined with other embodiments described herein, the control device is configured to adjust at least one of the print parameters based on a printing time, e.g., a time elapsed since starting to printing process. By controlling or adjusting at least one of said parameters based on the printing time, different printing conditions for instance in different screen regions can be considered/compensated, and thus, a homogeneity of the printed structures can be improved.

According to some embodiments, which could be combined with other embodiments described herein, the control device is configured to adjust at least one of the print parameters based on a position of the squeegee 142 with respect to the screen device 130. By controlling or adjusting at least one of said parameters based on a position of the squeegee 142, different printing conditions for instance in different screen regions can be considered/compensated, and thus, a homogeneity of the printed structures can be improved.

According to some embodiments, which could be combined with other embodiments described herein, the control device is configured to adjust the pressure of the squeegee 142 acting on the screen device 130 by controlling the translation device 141 to increase or decrease a distance of the squeegee 142 with respect to the screen device 130. As an example, the squeegee 142 is moveable by the translation device 141 in z (146)-direction with respect to the screen device 130. This allows for a precise control of the pressure acting on the screen.

The substrate 110 according to the embodiments described herein may include at least one of a conductive material, particularly with silicon or aluminum, a plate, a wafer, a foil, a semiconductor wafer, a solar cell wafer, a silicon solar cell waver, a green-tape circuit board, which can particularly be used to form photovoltaic cells.

According to some embodiments, which could be combined with other embodiments described herein, the substrate support 110 is configured to support the substrate 120. In typical embodiments, the substrate support 110 may include a nest or other support, on which the substrate 120 can be placed for printing.

According to some embodiments, which could be combined with other embodiments described herein, the screen device 130 includes a screen frame 131 and a screen 132 hold by said screen frame 131. According to some embodiments, which could be combined with other embodiments described herein, the screen device 130 includes the screen 132, but does not include the screen frame 131. In typical embodiments, the substrate support 110 and the screen device 130 may be moveable with respect to each other.

According to some embodiments, which could be combined with other embodiments described herein, the screen 132 may include at least one of a net, a printing mask, a sheet, a metal sheet, a plastic sheet, a plate, a metal plate, and a plastic plate. In typical embodiments, the screen 132 defines a pattern or features corresponding to a structure to be printed on the substrate, wherein the pattern or features may include at least one of holes, slots, incisions or other apertures. In typical embodiments, a tip 143 of the squeegee 142 contacts the screen 132, wherein the squeegee 142 urges material to be printed onto the substrate 120 through the screen 132.

According to some embodiments, which could be combined with other embodiments described herein, a solar cell production apparatus is provided, including one or more printing stations, at least one of them having an apparatus 100 for screen printing described above.

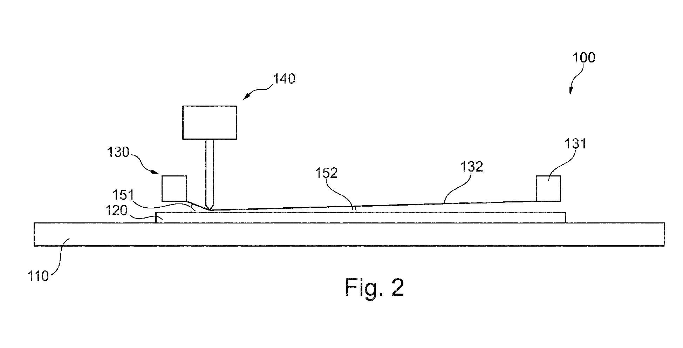

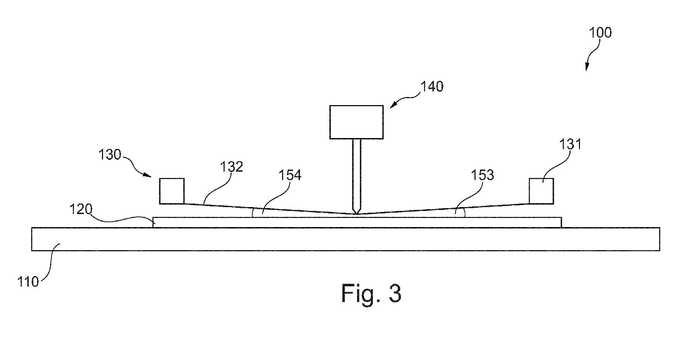

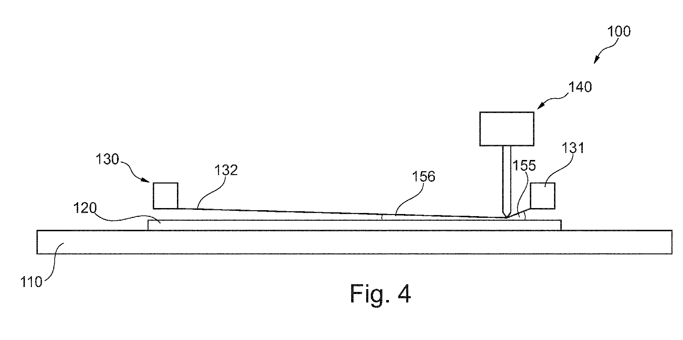

FIG. 2 illustrates the apparatus 100 for screen printing with the squeegee 142 contacting the screen at an initial position. FIG. 3 illustrates the apparatus 100 for screen printing with the squeegee 142 contacting the screen 132 during printing. FIG. 4 illustrates the apparatus 100 for screen printing with the squeegee 142 contacting the screen 132 at a final position after completion of the printing process.

According to some embodiments, which could be combined with other embodiments described herein, the squeegee 142 may be configured to move from a first position (e.g., the initial position shown in FIG. 2) along at least one direction with respect to the screen device to a second position (e.g., the final position shown in FIG. 4). Thereby, a printing path could be defined.

As shown in FIG, 2, at the beginning of the printing process when the squeegee 142, and particularly the tip 143 thereof, contacts the screen 132, said screen 132 is deformed and forms angles 151 and 152 with respect to the substrate 120. As explained above, the printing conditions are not the same during printing. In the example shown in FIGs. 2 to 4, the angles 151 and 152 change during printing, as does the squeegee pressure acting on the screen (basically due to a different screen deformation during printing and therefore a different behavior of the screen 132). The present embodiments may control at least on process parameter in real time to counteract or compensate the change of the printing conditions. As an example, at least one of the squeegee pressure, the angle and/or speed of the squeegee with respect to the screen device 130, and a distance of the squeegee 142 with respect to the screen device 130 (snap off) is adjusted or controlled.

In typical embodiments, controlling the at least one print parameter may include at least one of the following: dynamic control of snap off, dynamic control of printing (squeegee) speed, and dynamic control of printing (squeegee) pressure. Dynamic control of the snap off may include changing the z- position of the print head (processing /translation device 140, 141) to modify the snap off continuously, e.g., in terms of milliseconds. Hereto, a profile using an axis (virtual or not) as reference could be generated and used. Dynamic control of printing (squeegee) speed may include changing the speed according to process needs or requirements. Hereto, a profile using an axis (virtual or not) as reference could be generated and used. Dynamic control of printing (squeegee) pressure could include changing the printing pressure in order to modify a finger and/or busbars shape according to process requirements or needs. Hereto, a pressure profile using a virtual axis could be generated and used.

FIG. 3 shows the screen printing apparatus 100 with the squeegee 142 contacting the screen 132 for printing during printing. The screen 132 is deformed and forms angles 153 and 154 with respect to the substrate 120, which angles may be different from the angles 151 and 152 formed at the beginning of the printing (see FIG. 2). FIG. 4 shows the screen printing apparatus 100 with the squeegee 142 contacting the screen 132 for printing at a final position after completion of the printing process. The screen 132 is deformed and forms angles 155 and 156 with respect to the substrate 120, which angles may be different from the angles 151, 152, 153 and 154 shown in FIGs. 2 and 3.

FIG. 5 illustrates another apparatus 200 for screen printing on a substrate 120 according to embodiments disclosed herein. The apparatus 200 is similar to the screen printing apparatus 100 shown is FIGs. 1 to 4, the difference being that the apparatus 200 of FIG. 5 further includes pressure sensors 147, 111 and 112 configured to detect a force or pressure of the squeegee 142 acting on the screen 132, the substrate 120 and/or the substrate support 110.

According to some embodiments, which could be combined with other embodiments described herein, at least one of the one or more pressure sensors 147 is provided at the translation device 141. In typical embodiments, one or two sensors are provided at the translation device 141.

According to some embodiments, which could be combined with other embodiments described herein, at least one of the one or more pressure sensors 111, 112 is provided at the substrate support 110. In typical embodiments, one, two, three or four sensors 111, 112 are provided at the translation device 141. According to some embodiments, three or four sensors 111, 112 are provided at the substrate support 110, e.g., in a quadrangular or rectangular shape.

According to some embodiments, which could be combined with other embodiments described herein, at least one of the one or more pressure sensors is provided at the screen device 130 (not shown).

According to some embodiments, which could be combined with other embodiments described herein, the pressure sensors may include load cells, strain gauges, piezoelectric elements, piezoresistive elements, Hall-effect devices, and the like. In typical embodiments at least one of the sensors 147, 111 and 112 is configured to detect a force acting in a direction towards the substrate 110, and/or is configured to detect a force acting on the substrate 120 and/or the substrate support 110. In typical embodiments, the force acting on the substrate 120 or substrate support 110 is a force acting approximately perpendicular to a surface of the substrate 120 or substrate support 110. According to some embodiments, which could be combined with other embodiments described herein, the pressure sensors 147, 111 and 112 are configured to detect a force component acting approximately perpendicular to a surface of the substrate 120 or substrate support 110. In the following, this force or force component is referred to as "printing force".

According to some embodiments, which could be combined with other embodiments described herein, the printing force may define a pressure, e.g., an overall pressure, on the substrate 120. Thus, the printing force may be defined as a total force of the processing device 140 (e.g., measured by sensor 174 provided at the translation device 141) minus a reaction force of the screen device 132 (e.g., measured by the at least one pressure sensor provided at the screen device 130 (not shown)).

According to some embodiments, which could be combined with other embodiments described herein, the reaction force of the screen device 130 depends on a position of the squeegee 142 with respect to the screen device 130. Referring to FIG. 3, the reaction force may be smaller around the center of the screen device than at edge portions (see FIGs. 2 and 4). Thus, the printing force acting on the substrate 110 is not constant during printing. According to typical embodiments described herein, the printing force may be varied during printing, e.g., by controlling or adjusting at least one print parameter such as the distance of the squeegee 142 with respect to the screen device 132, to keep the printing force approximately constant or within a predefined range during printing.

According to some embodiments, which could be combined with other embodiments described herein, the one or more sensors 147, 111 and 112 are connected to the control device. In typical embodiments, the control device may use information received from the one or more sensors 147, 111 and 112 to determine the printing force, for instance a force of the squeegee 142 / processing device 140 acting on the screen 130, the substrate 120 and/or the substrate support 120.

According to some embodiments, the control device may be configured to determine a position and/or moving speed of the squeegee 142 with respect to the screen device 130. In typical embodiments, the control device may control the printing process, e.g., by controlling or adjusting at least one of the print parameters according to the predetermined pattern based on the information received from the one or more sensors 147, 111 and 112 and/or the information derived therefrom (e.g., printing force and/or moving speed and/or position of the squeegee 142).

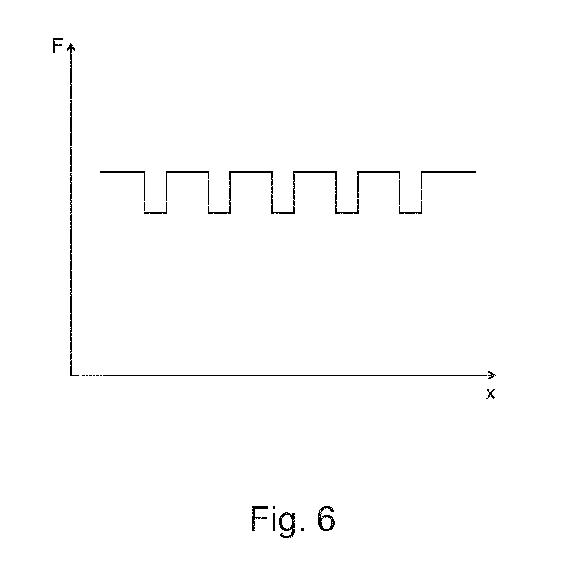

FIG. 6 illustrates a predetermined pattern for controlling a print parameter of the squeegee during printing according to embodiments disclosed herein. The x-axis denoted a moving direction of the squeegee or a time, e.g., a printing time. In this example, the print parameter controlled during printing is a pressure F of the squeegee acting on the screen, wherein at positions of tracks, the pressure is reduced in order to achieve a planar upper surface of the printed tracks. The pressure F may be controlled by controlling or adjusting the distance of the squeegee with respect to the screen device (snap off). Thereby, an improved quality particularly in terms of printing homogeneity, correct dimensions (e.g., height and/or width) of the printed structures (e.g., fingers and/or busbars) can be achieved.

According to some embodiments, which could be combined with other embodiments described herein, controlling the print parameter may further include controlling the pressure F such that a printing force acting on the screen 132 substrate 120 or substrate support 110 is approximately constant or within a predefined range, e.g., when moving from a first position (e.g., the initial position shown in FIG. 2) to a second position (e.g., the final position in FIG. 4).

Although the print parameter shown in FIG. 6 is the squeegee pressure F (which may be defined or correspond to the distance of the squeegee with respect to the screen device (snap off)), the predetermined pattern shown in FIG. 6 could also denote the moving speed of the squeegee with respect to the screen device or the angle of the squeegee with respect to the screen device, as will be explained below.

According to some embodiments, which could be combined with other embodiments described herein, controlling the print parameter may further include controlling of at least one of the angle of the squeegee with respect to the screen device, and a moving speed of the squeegee with respect to the screen device.

Referring to FIG. 1 again, according to some embodiments, which could be combined with other embodiments described herein, the angle 147, 148 of the squeegee 142 with respect to the screen device 130 is defined as an angle between a surface of the screen device 132 or screen 132, and a longitudinal extension of the squeegee 142. In the embodiment shown in FIG. 1, when the squeegee is oriented perpendicular to the screen device 130, the angle 147 is approximately 90°. In typical embodiments, the angle is adjustable by an amount Delta from its perpendicular orientation.

According to some embodiments, the angle may be controlled based on a presence or density of the pattern or features of the screen. As an example, the angle may be controlled to be higher in screen regions where the pattern or features are present, and may be lower or reduced in other regions, e.g., regions having no pattern or features (see also pattern in FIG. 6).

According to some embodiments, which could be combined with other embodiments described herein, the moving speed of the squeegee 142 with respect to the screen device 130 is adjusted during printing according to the predetermined pattern. In typical embodiments, the screen 132 defines a pattern or features corresponding to a structure to be printed on the substrate, wherein the pattern or features may include at least one of holes, slots, incisions or other apertures. In typical embodiments, a tip 143 of the squeegee 142 contacts the screen 132, wherein the squeegee 142 urges material to be printed onto the substrate 120 through the screen 132.

According to some embodiments, the moving speed may be controlled based on a presence or density of the pattern or features of the screen. As an example, the moving speed may be controlled to be higher in screen regions where the pattern or features are present, and may be lower or reduced in other regions, e.g., regions having no pattern or features (see also pattern in FIG. 6). According to some embodiments, the moving speed is higher at the beginning and the end of the printing process, and is reduced in between. In typical embodiments, the moving speed could be lower at the beginning of the printing process (e.g., at the input), higher when more paste is required (e.g., at or near busbars), lower between printing patterns (e.g., between the busbars), and higher at the end of the printing process (e.g., on exit).

According to another aspect, an apparatus for screen printing on a substrate includes a substrate support configured to support the substrate, a recovery device moveable in at least one direction along the substrate for recovery of excess print material, and a control device configured to control, during operation, particularly a recovery operation or printing, one or more recovery parameters of the recovery device, wherein at least one of the one or more recovery parameters is amended during operation according to another predetermined pattern.

As an example, the recovery device moveable in at least one direction along the screen device provided between the substrate/substrate support and the recovery device for recovery of excess printing material, wherein the control device is further configured to control, during operation, particularly printing, one or more recovery parameters of the recovery device, wherein at least one of the one or more recovery parameters is amended during operation according to the another predetermined pattern.

In typical embodiments, the recovery parameters correspond to the print parameters of the squeegee and/or the other predetermined pattern of the recovery parameters corresponds to the predetermined pattern of the print parameters. As an example, the recovery device can be controlled in the same way as the squeegee described above with reference to FIGs. 1 to 6 and FIG. 7 below. Thus, the description given with respect to the apparatus and the control of the squeegee according to a predetermined pattern also applies to the apparatus and the control of the recovery device according to another predetermined pattern. Particularly, the recovery device may be controlled according to the same predetermined pattern as the squeegee. In typical embodiments, the recovery parameters may be the same as or identical to the print parameters of the squeegee described above.

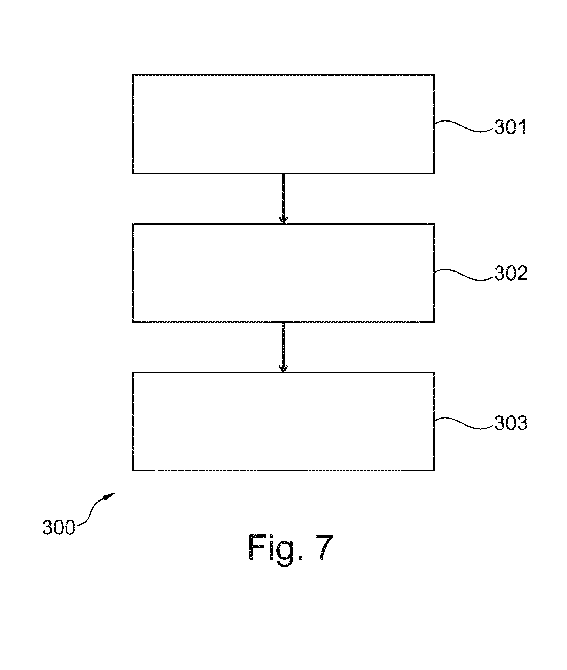

FIG. 7 shows a flowchart of a method 300 for screen printing on a substrate according to embodiments described herein. According to some embodiments, the method 300 may utilize the apparatus 100 or 200 described above with reference to FIGs. 1 to 5.

According to some embodiments, which could be combined with other embodiments described herein, the method may include contacting the screen by the squeegee (block 301), start moving of the squeegee with respect to the screen for printing (block 302), and controlling, during printing, one or more print parameters of the squeegee according to a predetermined pattern (block 303).

According to some embodiments, the method may include contacting the screen by the squeegee (block 301), start moving of the squeegee with respect to the screen for printing (block 302), and adjusting an angle of the squeegee with respect to the screen device during printing (block 303).

In typical embodiments, the method may further include adjusting at least one of the print parameters based on a position of the squeegee with respect to the screen. In some implementations, the method may further include adjusting a pressure of the squeegee acting on the screen by controlling a distance of the squeegee with respect to the screen.

In some embodiments, which could be combined with other embodiments disclosed herein, the method may further include controlling, during an operation, e.g., printing, one or more recovery parameters of a recovery device, wherein at least one of the one or more recovery parameters is amended during printing according to another predetermined pattern. In typical implementations, the recovery parameters correspond to the print parameters of the squeegee and/or the other predetermined pattern of the recovery parameters corresponds to the predetermined pattern of the print parameters.

The present disclosure provides an apparatus for screen printing on a substrate. According to the embodiments described herein, to improve a printing quality, dynamic variations (i.e., real-time variations during printing) of at least one of the print parameters are performed in order to obtain an improved printing, e.g., on solar cells. Thereby, an improved quality particularly in terms of printing homogeneity, correct dimensions (e.g., height and/or width) of the printed structures (e.g., fingers and/or busbars) can be achieved.

While the foregoing is directed to embodiments of the invention, other and further embodiments of the invention may be devised without departing from the basic scope thereof, and the scope thereof is determined by the claims that follow.

## Claims

1. An apparatus (100, 200) for screen printing on a substrate (120) for the production of a solar cell, comprising:
- a substrate support (110) configured to support the substrate (120);
- a squeegee (142);
- a screen device (130) provided between the substrate support (110) and the squeegee (142),
wherein the squeegee (142) is moveable in at least one direction along the screen device (130) for printing; and
- a control device configured to control, during printing, one or more print parameters of the squeegee (142), wherein at least one of the one or more print parameters is amended during printing according to a predetermined pattern.

2. The apparatus (100) of claim 1, wherein the one or more print parameters include at least one of
- an angle (147, 148) of the squeegee (142) with respect to the screen device (130);
- a moving speed of the squeegee (142) with respect to the screen device (130); and
- a pressure of the squeegee (142) acting on the screen device (130).

3. The apparatus (100) of claim 1 or 2, wherein the predetermined pattern includes at least one of
- a sequence of print parameters based on printing time; and
- a sequence of print parameters based on a position of the squeegee (142) with respect to the screen device (130);

4. The apparatus (100) of one of claims 1 to 3, further including one or more pressure sensors (111, 112, 147) configured to detect a pressure of the squeegee (142) acting on the screen device (130).

5. The apparatus (100) of one of claims 1 to 4, further including a translation device (141), which is configured for moving the squeegee (142) in the at least one direction with respect to the screen device (130), and particularly wherein the squeegee (142) is attached to the translation device (141).

6. The apparatus (100) of one of claims claim 4 to 5, wherein at least one of the one or more pressure sensors (111, 112) is provided at the substrate support (110) and/or wherein at least one of the one or more pressure sensors is provided at the screen device (130) and/or wherein at least one of the one or more pressure sensors (147) is provided at the translation device (141).

7. The apparatus (100) of one of claims 5 or 6, wherein the translation device (141) is configured to adjust at least one of the one or more print parameters based on a control of the control device.

8. The apparatus (100) of one of claims 1 to 7, wherein the control device is configured to adjust at least one of the print parameters based on a position of the squeegee (142) with respect to the screen device (130) and/or wherein the control device is configured to adjust the pressure of the squeegee (142) acting on the screen device (130) by controlling a distance of the squeegee (142) with respect to the screen device (130).

9. The apparatus (100) of one of claims 1 to 8, further including a recovery device moveable in at least one direction along the screen device (130) for recovery of excess printing material, wherein the control device is further configured to control, during operation, particularly printing, one or more recovery parameters of the recovery device, wherein at least one of the one or more recovery parameters is amended during operation according to another predetermined pattern.

10. The apparatus (100) of claim 9, wherein the recovery parameters correspond to the print parameters of the squeegee (142) and/or the other predetermined pattern of the recovery parameters corresponds to the predetermined pattern of the print parameters.

11. A solar cell production apparatus, comprising:
one or more printing stations, at least one of them having an apparatus (100, 200) for screen printing according to one of claims 1 to 10.

12. A method (300) for screen printing on a substrate, comprising:
- contacting (301) a screen by a squeegee,
- moving (302) the squeegee with respect to the screen for printing, and
- controlling (303), during printing, one or more print parameters of the squeegee according to a predetermined pattern.

13. Method (300) of claim 12, further including adjusting at least one of the print parameters based on a position of the squeegee with respect to the screen.

14. Method (300) of claim 12 or 13, further including adjusting a pressure of the squeegee acting on the screen by controlling a distance of the squeegee with respect to the screen.

15. Method of one of claims 12 to 14, further including controlling, during printing, one or more recovery parameters of a recovery device, wherein at least one of the one or more recovery parameters is amended during printing according to another predetermined pattern.
